# EUROPEAN PATENT SPECIFICATION

(11) **EP 1 480 278 B1**
(45) Date of publication and mention of the grant of the patent: **19.06.2013**
(21) Application number: 04252504.8
(22) Date of filing: 29.04.2004
(51) Int. Cl.: H01L 33/50

(54) **Light emitting diode comprising a fluorescent multilayer**
Leuchtdiode mit fluoresierender Mehrschichtstruktur
Diode électroluminescente à couches multiples fluorescentes

(30) Priority: 30.04.2003 KR 2003027546
(43) Date of publication of application: 24.11.2004
(73) Proprietor: Samsung Electronics Co., Ltd., Suwon-si, Gyeonggi-do, 443-742 (KR)
(72) Inventor: Cho, Jae-hee, c/o 202-1201 Sinil Apt., Yongin-si, Gyeonggi-do (KR); Jeoung, Moon-sook, c/o 101-603 Paradise Apt., Seoul (KR); Jeong, Dae-soo, c/o Samsung Advanced Inst., Yongin-si, Gyeonggi-do (KR)
(74) Representative: Greene, Simon Kenneth

(56) References cited:
- EP-A- 1 433 831
- WO-A-01/24283
- US-A1- 2003 038 295

## Description

The present invention relates to a light emitting diode device, and more particularly, to a light emitting diode device having a fluorescent multilayer, which can provide a high light conversion efficiency.

A light emitting diode (LED) device emits white light or visible rays of a variety of colors by converting ultraviolet (UV) rays or blue light emitted from an LED chip into light with a longer wavelength. For example, UV rays emitted from an LED chip in a LED device that emits white light excite fluorescent materials, and accordingly, visual rays of three primary colors, i.e., red (R), green (G), and blue (B), are emitted from the excited fluorescent materials. Different colored visual rays may be emitted from the fluorescent materials depending on the composition of the fluorescent materials. A combination of visual rays could appear as white light to human eyes.

LED devices have been developed from a lamp-type to a chip-type. Chip-type LED devices can be easily mounted on a large-sized substrate with high integration density. Accordingly, such LED devices have been widely adopted in many different fields as backlighting devices, electric illumination devices, such as florescent lamps, or other signal devices, and their range of application is expected to become much wider.

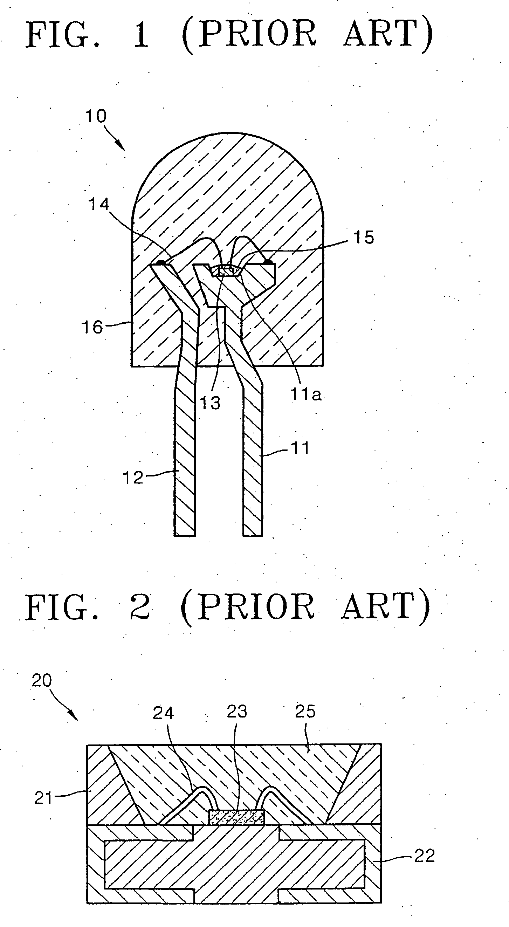

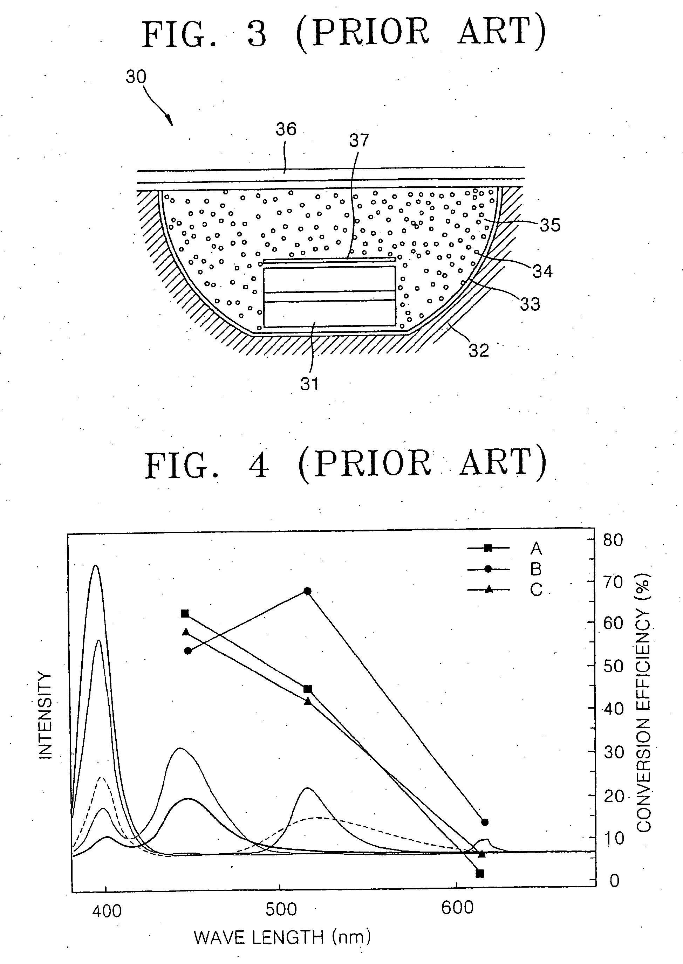

FIGS. 1 through 3 are cross-sectional views of three different conventional LED devices. FIGS. 1 and 2 illustrate a conventional lamp-type LED device 10 and a conventional chip-type LED device 20, respectively, which have already been disclosed in U.S. 6,069,440. FIG. 3 illustrates a conventional LED device 30 disclosed in U.S. 5,813,753.

Referring to FIG. 1, the conventional lamp-type LED device 10 includes a mount lead 11, an inner lead 12, and an LED chip 13. The LED chip 13 is installed inside a cup 11a formed on the mount lead 11. An n-electrode and a p-electrode of the LED chip 13 are electrically connected to the mount lead 11 and the inner lead 12, respectively, via a wire 14. The LED chip 13 is covered with a fluorescent layer 15, which is formed of a mixture of a coating resin and fluorescent materials. Part of the mount lead 11, part of the inner lead 12, the cup 11a, the LED chip 13, the wire 14, and the fluorescent layer 15 are surrounded by a transparent resin 16.

Referring to FIG. 2, in the conventional chip-type LED device 20, an LED chip 23 is installed in a groove of a casing 21. A fluorescent layer 25 is formed to cover the LED chip 23 by filling the groove of the casing 21 with a mixture of a coating resin and fluorescent materials. An n-electrode and a p-electrode of the LED chip 23 are connected to a metal conducting wire 22 via a wire 24.

Referring to FIG. 3, in the conventional LED device 30, an LED chip 31 is installed in a header 32having a cup shape, and a mirror 33, which is installed at an inner wall of the header 32, reflects rays of light emitted from the LED chip 31. The header 32 is filled with a transparent material having fluorescent materials scattered all over the place therein so that the LED chip 31 is surrounded by the transparent material. A plate glass 36, which is placed over the header 32, prevents light that is yet to be absorbed into the fluorescent materials 34 from being emitted to the air. A short wave pass (SWP) filter 37, which is formed on the LED chip 31, transmits light with a shorter wavelength more efficiently than light with a longer wavelength.

In such conventional LED devices, ultraviolet rays or blue rays excite fluorescent materials in a fluorescent layer, and then the excited fluorescent layer emits visual rays of a longer wavelength. For example, in an LED device that emits white light using an ultraviolet LED chip, three different types of fluorescent materials in a fluorescent layer, which respectively emit red, green, and blue rays when being excited by ultraviolet rays, are mixed up, or two different types of fluorescent materials, which respectively emit yellow and blue rays when excited by ultraviolet rays, are mixed up. On the other hand, in an LED device that emits white rays using a blue LED chip, two different types of fluorescent materials, which respectively emit red and green rays when excited by blue rays, are mixed up.

FIG. 4 is a graph illustrating light conversion efficiencies of three different conventional fluorescent materials A, B, and C when excited by an ultraviolet ray of 20 mA. Referring to FIG. 4, the fluorescent materials A, B, and C have a high light conversion efficiency of about 60% when emitting blue rays with a wavelength of about 450 nm. The fluorescent materials A, B, and C also have a relatively high light conversion efficiency of about 40% when emitting green rays with a wavelength of about 520 nm. However, when emitting red rays with a wavelength of about 620 nm, the fluorescent materials A, B, and C have as low a light conversion efficiency as 15% or lower.

Such low light conversion efficiency of the fluorescent materials A, B, and C when emitting red rays affects the entire light conversion efficiency of an LED device so badly that strenuous efforts are currently being made to develop an LED device having a higher light conversion efficiency.

Prior art LED devices including fluorescent multilayer films include WO01/24283 and US 2003/0038295. The former describes chip-red-green and chip-blue-yellow arrangements. Other combinations of layers are described by the latter document.

The present invention provides a light emitting diode (LED) device having a fluorescent multilayer, which can provide a high light conversion efficiency.

According to the present invention, there is provided a light emitting diode (LED) device as set out in claim 1. The LED device includes an LED chip, which emits ultraviolet light, and a fluorescent multilayer, which is comprised of a plurality of fluorescent layers that emit light having different wavelengths from one another when being excited by the ultraviolet light emitted by the LED chip. Light of a longer wavelength is emitted from a portion of the fluorescent multilayer closer to the LED chip, and light of a shorter wavelength is emitted from a portion of the fluorescent multilayer farther away from the LED chip.

The fluorescent multilayer includes a first fluorescent layer, which is formed on the LED chip and emits yellow light, and a second fluorescent layer, which is deposited on the first fluorescent layer and emits blue light.

The first fluorescent layer contains a fluorescent material that emits yellow light having a wavelength of 560 nm - 580 nm, and the second fluorescent layer contains a fluorescent material that emits blue light having a wavelength of 420 nm - 480 nm.

As described above, according to the present invention, the entire light conversion efficiency of an LED device increases due to an increase in the light conversion efficiency of a fluorescent layer that emits light with a longest wavelength, and accordingly, the amount of light output increases.

The above and other features and advantages of the present invention will become more apparent by describing in detail exemplary embodiments thereof with reference to the attached drawings in which:
FIGS. 1 through 3 are cross-sectional views of three different conventional light emitting diode (LED) devices;
FIG. 4 is a graph illustrating light conversion efficiencies of three different conventional fluorescent materials that emit red, green, and blue rays;
FIGS. 5A and 5B are cross-sectional views of a lamp-type LED device according to a first comparative example and a chip-type LED device according to a second comparative example of the present invention, respectively;
FIG. 6 is a cross-sectional view of an LED device of a further comparative example;
FIG. 7 is a cross-sectional view of an LED device according to an embodiment of the present invention;
FIG. 8 is a cross-sectional view of an LED device according to a further comparative example
FIG. 9 is a diagram for comparing the light conversion efficiency of the LED device according to Figure 6 with that of a conventional LED device; and
FIG. 10 is a diagram for comparing the light conversion efficiency of the LED device according to the embodiment of Figure 7 of the present invention with that of a conventional LED device.

Hereinafter, the present invention will be described more fully with reference to the accompanying drawings 7 and 10 in which an exemplary embodiment of the invention is shown. The invention may, however, be embodied in many different forms and should not be construed as being limited to the embodiment set forth herein. Rather, this embodiment is provided so that this disclosure will be thorough and complete, and will convey the concept of the invention to those skilled in the art. In the drawings, the thicknesses of layers and regions are exaggerated for clarity. In different drawings, the same reference numerals represent the same elements.

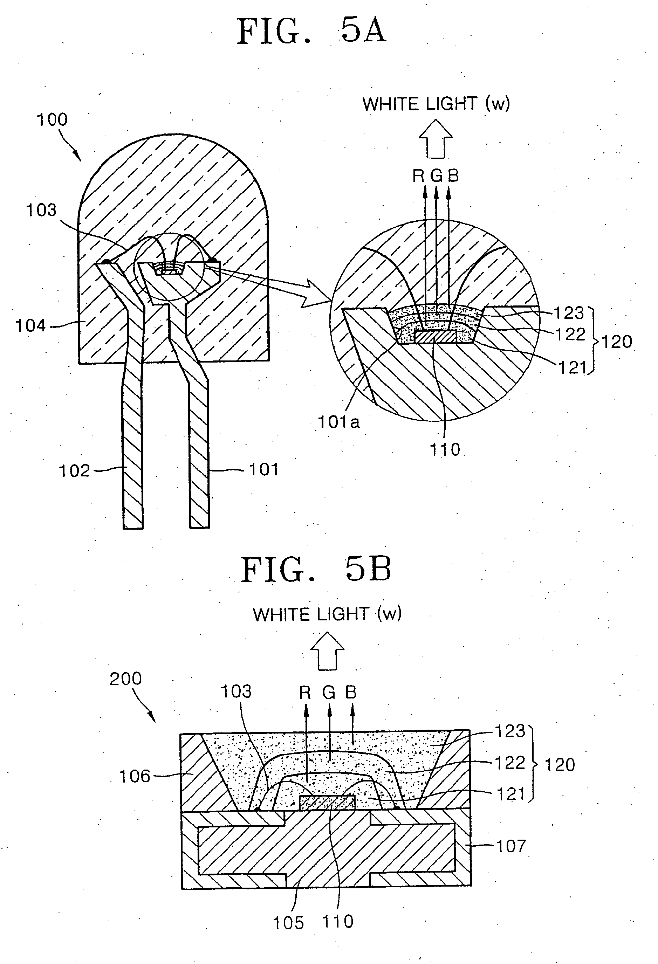

FIGS. 5A and 5B are cross-sectional views of a lamp-type LED device 100 according to a comparative example and a chip-type LED device 200 according to another comparative example of the present invention, respectively.

Referring to FIG. 5A, the lamp-type LED device 100 includes a mount lead 101, an inner lead 102, and an LED chip 110, which is placed inside a cup 101a formed on the mount lead 101 and generates ultraviolet rays having a wavelength of about 410 nm or shorter. In the present comparative example, ultraviolet (UV) rays are used to excite fluorescent materials contained in a fluorescent multilayer 120. An n-electrode and a p-electrode of the LED chip 110 are electrically connected to the mount lead 101 and the inner lead 102, respectively, via a wire 103. The LED chip 110 is covered with a fluorescent multilayer 120, and the fluorescent multilayer 120 is comprised of three fluorescent layers 121 through 123 formed of three different fluorescent materials. The mount lead 101, the inner lead 102, the wire 103, the cup 101a, and the LED chip 110 are surrounded by a transparent resin 104, such as epoxy resin.

Referring to FIG. 5B, in the chip-type LED device 200, an LED chip 110, which emits UV rays, is installed in a casing 106 formed on a substrate 105. In a groove of the casing 106, three fluorescent layers respectively formed of three different fluorescent materials, i.e., first, second and third fluorescent layers 121, 122, and 123, are formed. The first through third fluorescent layers 121 through 123 constitute a fluorescent multilayer 120. An n-electrode and a p-electrode of the LED chip 110 are electrically connected to a metal wire formed on the substrate 105 via a wire 103.

As shown in FIGS. 5A and 5B, the LED devices 100 and 200 according to the first and second comparative examples, respectively, both include the fluorescent multilayer 120 formed on the LED chip 110. The fluorescent multilayer 120 is comprised of the first through third fluorescent layers 121 through 123, and the first through third fluorescent layers 121 through 123 contain different fluorescent materials that emit rays of different colors when excited by UV rays.

More specifically, the first fluorescent layer 121 is formed of a mixture of epoxy resin and silicon resin and a fluorescent material that emits red light R on the UV LED chip 110. The first fluorescent layer 121 may be formed of a fluorescent material that emits light with a wavelength of 580 nm ∼ 700 nm, more specifically, 600 nm - 650 nm when excited by UV rays. For example, SrS:Eu²⁺, Y₂O₂S:Eu, YVO:Eu, or M(WO):Eu,SM(M;Li, Na, K, Ba, Ca, or Mg) could be used as the fluorescent material.

The second fluorescent layer 122 is deposited on the first fluorescent layer 121 and is formed of a mixture of epoxy resin, silicon resin, and a fluorescent material that emits green light (G). The second fluorescent layer 122 may be formed of a fluorescent material that emits light with a wavelength of 500 nm - 550 nm when excited by UV rays. For example, TG(SrGa₂S₄:Eu²⁺) or (BaSr)SiO:EuM(M;Ho, Er, Ce or Y) could be used as the fluorescent material.

The third fluorescent layer 123 is deposited on the second fluorescent layer 122 and is formed of a mixture of epoxy resin, silicon resin, and a fluorescent material that emits blue light (B). The third fluorescent layer 123 may be formed of a fluorescent material that emits light with a wavelength of 420 nm ∼ 480 nm when excited by UV rays. For example, Ca₁₀(PO₄)₆Cl₂:Eu²⁺ or Sr₅(PO₄)₃Cl:Eu could be used as the fluorescent material.

In the LED devices 100 and 200 according to the first and second comparative examples, respectively, UV rays emitted from the LED chip 110 excites the three different fluorescent materials contained in the first through third fluorescent layers 121 through 123. Accordingly, red light, green light, and blue light are emitted from the first, second, and third fluorescent layers 121, 122, and 123, respectively. A combination of the red, green, and blue lights, emitted from the first, second, and third fluorescent layers 121, 122, and 123, respectively, can be seen as white light (W) to human eyes.

In the first and second comparative examples of the present invention, the fluorescent multilayer 120 is formed of a multiple layer, i.e., a triple layer. More specifically, the first fluorescent layer 121 that emits red light is deposited on the LED chip 110, and the second and third fluorescent layers 122 and 123 that emit green light and blue light, respectively, are sequentially deposited on the first fluorescent layer 121. By placing the first fluorescent layer 121 that emits red light, for which a lowest light conversion efficiency is obtained, at a position closest to the LED chip 110, the light conversion efficiency of the first fluorescent layer 121 can become relatively higher, and thus the light conversion efficiency of the entire LED device 100 or 200 can be enhanced.

If the third, second, and first fluorescent layers 123, 122, and 121 are sequentially deposited on the LED chip 110 so that the third fluorescent layer 123 that emits blue light with a shortest wavelength can be placed at the position closest to the LED chip 110 and the first fluorescent layer 121 can be placed at a position farthest away from the LED chip 110, UV rays emitted from the LED chip 110 are absorbed into the third and second fluorescent layers 123 and 122 before they reach the first fluorescent layer 121. Thus, the light conversion efficiency of the first fluorescent layer 121 becomes much lower.

Therefore, in the comparative examples, the first, second, and third fluorescent layers 121, 122, and 123 are sequentially deposited on the LED chip 110 so that the first fluorescent layer 121 can be placed at the position closest to the LED chip 110, the third fluorescent layer 123 can be placed at the position farthest away from the LED chip 110, and the second fluorescent layer 122 can be placed between the first and third fluorescent layers 121 and 123.

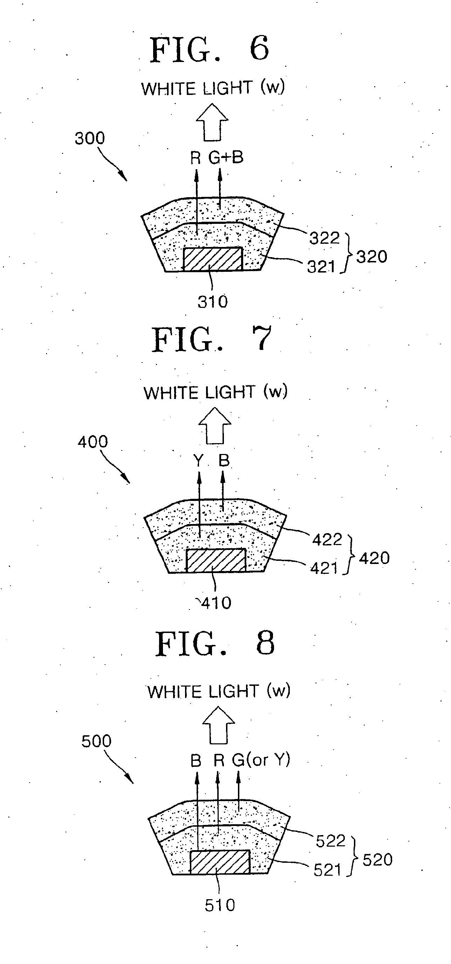

FIGS. 6 through 8 are cross-sectional views of LED devices according to further comparative examples. FIGS. 6 through 8 illustrate only distinctive features of LED devices 300, 400, and 500, respectively, to the LED devices 100 and 200 according to the first and second comparative examples, respectively, of the present invention, shown in FIGS. 5A and 5B, respectively. In other words, the LED devices 300, 400, and 500 may be realized as lamp-type or chip-type ones.

Referring to FIG. 6, the LED device 300 includes an LED chip 310, which emits UV rays with a wavelength of 410 nm or shorter as excitation light, and a fluorescent multilayer 320, which is formed to cover the LED chip 310. In the present comparative example, the fluorescent multilayer 320 is formed of a double layer comprised of first and second fluorescent layers 321 and 322.

More specifically, the first fluorescent layer 321 is formed of a mixture of epoxy resin, silicon resin, and a fluorescent material that emits red light (R) on the LED chip 310. Examples of the fluorescent material and the wavelength range of red light emitted from the fluorescent material have already been described above, and thus their explanations will not be presented here again.

The second fluorescent layer 322, which is deposited on the first fluorescent layer 321, is formed of a mixture of epoxy resin, silicon resin, and two different fluorescent materials that emit green light (G) and blue light (B), respectively. Examples of the fluorescent materials that respectively emit green light (G) and blue light (B) and the wavelength ranges of lights respectively emitted from the fluorescent materials have already been described above, and thus their explanations will not be presented here again.

In the LED device 300, UV rays emitted from the LED chip 310 excite the fluorescent material of the first fluorescent layer 321 and the fluorescent materials of the second fluorescent layer 322. As a result, red light (R) is emitted from the first fluorescent layer 321, and green light (G) and blue light (B) are emitted from the second fluorescent layer 322. A combination of the red, green, and blue lights (R), (G), and (B), emitted from the fluorescent multilayer 320, is seen as white light (W) to human eyes.

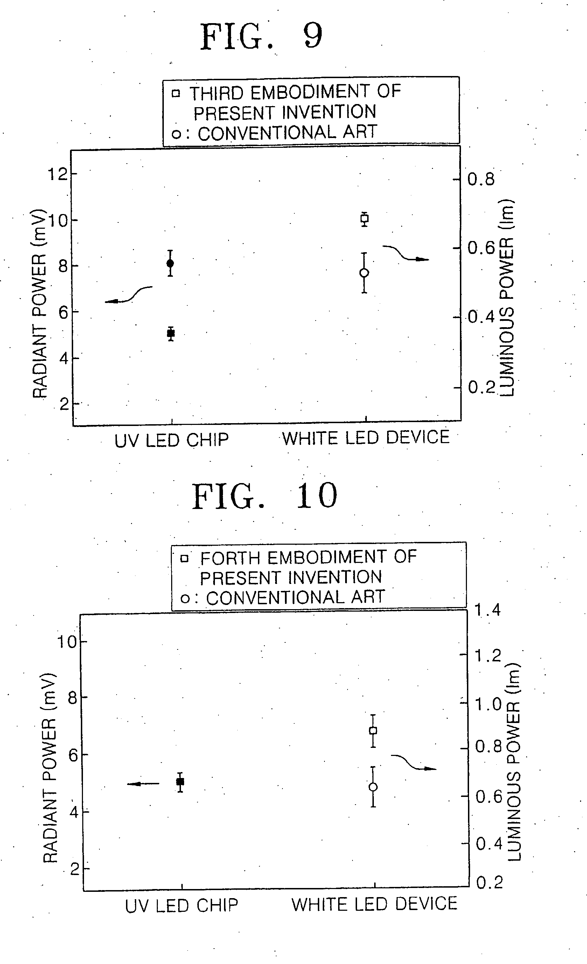

As described above, in the third comparative example of the present invention, the fluorescent layer 320 is formed of a double layer to convert UV rays into visual rays such that the first fluorescent layer 321, from which light of a longest wavelength, i.e., red light (R), is emitted, is deposited on the LED chip 310, and the second fluorescent layer, from which lights of a shorter wavelength, i.e., green light and blue light, are emitted, is deposited on the first fluorescent layer 321. Therefore, in the present comparative example, like in the previous comparative examples, light conversion efficiency can be enhanced, which will become more apparent from analyzing FIG. 9.

Referring to FIG. 7, the LED device 400 includes an LED chip 410, which emits UV rays having a wavelength of 410 nm or shorter as excitation light, and a fluorescent multilayer 420, which is formed to cover the LED chip 410. In this embodiment of the present invention, like in the third comparative example of the present invention, the fluorescent multilayer 420 is formed of a double layer comprised of first and second fluorescent layers 421 and 422.

More specifically, the first fluorescent layer 421 is formed of a mixture of a fluorescent material that emits yellow light (Y), epoxy resin, and silicon resin on the LED chip 410. The fluorescent material emits light having a wavelength of 560 nm - 580 nm when excited by UV rays. For example, yttrium aluminium garnet (YAG) could be used as the fluorescent material.

The second fluorescent layer 422 is formed of a mixture of epoxy resin, silicon resin, and a fluorescent material that emits blue light (B) on the first fluorescent layer 421. Examples of the fluorescent material and the wavelength range of blue light (B) emitted from the fluorescent material have already been described above in the previous comparative example, and thus their explanations will not be presented here again.

In the LED device 400, UV rays emitted from the LED chip 410 excite the fluorescent material of the first fluorescent layer 421 and the fluorescent material of the second fluorescent layer 422. As a result, yellow light (Y) is emitted from the first fluorescent layer 421, and blue light (B) is emitted from the second fluorescent layer 422. A combination of the yellow and blue lights (Y) and (B), emitted from the fluorescent multilayer 420, is seen as white light (W) to human eyes.

As described above, in the embodiment of Figure 7 of the present invention, the fluorescent layer 420 is formed of a double layer to convert UV rays into visual rays such that the first fluorescent layer 421, from which light of a longest wavelength, i.e., yellow light (Y), is emitted, is deposited on the LED chip 410, and the second fluorescent layer, from which light of a shorter wavelength, i.e., blue light (B), are emitted, is deposited on the first fluorescent layer 421. Therefore, in the present embodiment, like in the previous comparative examples, light conversion efficiency can be generally enhanced.

Referring to FIG. 8, the LED device 500 includes an LED chip 510, which emits blue light.(B) of a wavelength of 420 nm - 480 nm as excitation light, and a fluorescent multilayer 520, which is formed of a double layer comprised of first and second fluorescent layers 521 and 522 to cover the LED chip 510.

More specifically, the first fluorescent layer 521 is formed of a mixture of a fluorescent material that emits red light (R), epoxy resin, and silicon resin. Examples of the fluorescent material that emits red light (R) and the wavelength range of light emitted from the fluorescent material have already been described above, and thus their descriptions will not be repeated here.

The second fluorescent layer 522, which is deposited on the first fluorescent layer 521, is formed of a mixture of epoxy resin, silicon resin, and a fluorescent material that emits green light (G) or yellow light (Y). Examples of the fluorescent material that emits green light (G) or yellow light (Y) and the wavelength range of light emitted from the fluorescent material have already been described above, and thus their descriptions will not be repeated here.

In the LED device 500, blue light (B) emitted from the LED chip 510 excites the fluorescent material of the first fluorescent layer 521 such that red light (R) is emitted from the first fluorescent layer 521. In addition, the blue light (B) also excites the fluorescent material of the second fluorescent material 522 such that green light (G) or yellow light (Y) is emitted from the second fluorescent layer 522. A combination of the red light (R) and the green light (G) (or the yellow light (Y)), emitted from the fluorescent multilayer 520, and the blue light (B), emitted from the LED chip 510, is seen as white light (W) to human eyes.

As described above, in the Figure 8 comparative example of the present invention, the fluorescent multilayer 520 is formed of a double layer to convert UV rays into visual rays such that the first fluorescent layer 421, from which light of a longest wavelength, i.e., red light (R), is emitted, is deposited on the LED chip 410, and the second fluorescent layer, from which light of a shorter wavelength, i.e., green light (G) or yellow light (Y), are emitted, is deposited on the first fluorescent layer

Experimental results showing the performance of the LED devices 300 and 400 according to Figures 6 and 7, respectively, will now be presented.

FIG. 9 is a diagram for comparing the light conversion efficiency of the LED device 300 of FIG. 6 with that of a conventional LED device, and FIG. 10 is a diagram for comparing the light conversion efficiency of the LED device 400 of FIG. 7 with that of a conventional LED device.

In a first experiment, an LED device, like the LED device 300 of FIG. 6, in which a first fluorescent layer, from which red light (R) is emitted, is deposited on an LED chip that emits UV rays and a second fluorescent layer, from which green light (G) and blue light (B) are emitted, is deposited on the first fluorescent layer, and an LED device including a fluorescent layer, which is formed of a single layer using a mixture of fluorescent materials that respectively emit red light (R), green light (G), and blue light (B) were used as comparative examples of the present invention and the prior art, respectively. In addition, an LED chip that emits UV rays of about 5 mW was used in the LED device of Figure 6, and an LED chip that emits UV rays of about 8 mW was used in the conventional LED chip.

Results of the first experiment are illustrated in FIG. 9. Referring to FIG. 9, the LED device outputs white light having an average of 0.68 Im (2.3 mW) for UV rays of about 5 mW, while the conventional LED device outputs white light having an average of 0.53 Im (2.1 mW) for UV rays of about 8 mW. Accordingly, the light conversion efficiency of the LED device 300, which amounts to about 46 %, is much higher than the light conversion efficiency of the conventional LED device, which amounts to about 26 %.

In a second experiment, an LED device, like the LED device 400 of FIG. 7, in which a first fluorescent layer, from which yellow light (Y) is emitted, is deposited on an LED chip that emits UV rays and a second fluorescent layer, from which blue light (B) is emitted, is deposited on the first fluorescent layer, and an LED device including a fluorescent layer, which is formed of a single layer using a mixture of fluorescent materials that respectively emit yellow light (Y) and blue light (B) were used as examples of the present invention and the prior art, respectively. In addition, LED chips that emit UV rays of about 5 mW were respectively used in the LED device of the present invention and the conventional LED chip.

Results of the second experiment are illustrated in FIG. 10. Referring to FIG. 10, the LED device of the present invention outputs white light having an average of 0.884 Im (3.15 mW) for UV rays of about 5 mW, while the conventional LED device outputs white light having an average of 0.649 Im (2.16 mW) for UV rays of about 5 mW. Accordingly, the light conversion efficiency of the LED device 400 according to the embodiment of the present invention, which amounts to about 63 %, is much higher than the light conversion efficiency of the conventional LED device, which amounts to about 43 %.

The above-described experiment results indicate that the entire light conversion efficiency of an LED device can be enhanced by forming a first fluorescent layer that emits red light (R) and thus has a lowest light conversion efficiency on an LED chip because most UV rays emitted from the LED chip are absorbed into the first fluorescent layer, thus enhancing the light conversion efficiency of the first fluorescent layer.

As described above, a fluorescent layer is formed of a first fluorescent layer that emits light of a longest wavelength on an LED chip and fluorescent layers that emit light of a shorter wavelength deposited on the first fluorescent layer. By doing so, the light conversion efficiency of the first fluorescent layer increases. As such, it is possible to increase the entire light conversion efficiency of an LED device and the amount of light output from the LED device.

While the present invention has been particularly shown and described with reference to exemplary embodiments thereof, it will be understood by those of ordinary skill in the art that various changes in form and details may be made therein without departing from the scope of the present invention as defined by the following claim. For example, the LED device according to the present invention has been described above as emitting white light. However, the present invention is not restricted to the LED device that emits white light.

## Claims

1. A light emitting diode (LED) device comprising:
an LED chip (410), which emits ultraviolet light; and
a fluorescent multilayer (420), which is comprised of a plurality of fluorescent layers that emit light having different wavelengths from one another when being excited by the ultraviolet light emitted by the LED chip,
wherein the fluorescent layers are arranged such that light of a longer wavelength is emitted from a portion of the fluorescent multilayer closer to the LED chip, and light of a shorter wavelength is emitted from a portion of the fluorescent multilayer farther away from the LED chip;
**characterized in that** the fluorescent multilayer comprises a first fluorescent layer (421), which is formed on the LED chip and contains a fluorescent material that emits yellow light having a wavelength of 560 nm - 580 nm, and a second fluorescent layer (422), which is deposited on the first fluorescent layer and contains a fluorescent material that emits blue light having a wavelength of 420 nm - 480 nm.

## Patentansprüche

1. Leuchtdioden-(LED)-Bauelement, das Folgendes umfasst:
einen LED-Chip (410), der ultraviolettes Licht emittiert; und
eine fluoreszente Multischicht (420), die sich aus mehreren fluoreszenten Schichten zusammensetzt, die Licht mit unterschiedlichen Wellenlängen emittieren, wenn sie durch das von dem LED-Chip emittierte ultraviolette Licht angeregt werden,
wobei die fluoreszenten Schichten so angeordnet sind, dass Licht mit einer größeren Wellenlänge von einem dem LED-Chip näher liegenden Teil der fluoreszenten Multischicht emittiert wird und Licht einer kleineren Wellenlänge von einem weiter von dem LED-Chip weg liegenden Teil der fluoreszenten Multischicht emittiert wird;
**dadurch gekennzeichnet, dass** die fluoreszente Multischicht eine erste fluoreszente Schicht (421) umfasst, die auf dem LED-Chip ausgebildet ist und ein fluoreszentes Material enthält, das Gelblicht mit einer Wellenlänge von 560 nm - 580 nm emittiert, und eine zweite fluoreszente Schicht (422), die auf die erste fluoreszente Schicht abgesetzt ist und ein fluoreszentes Material enthält, das Blaulicht mit einer Wellenlänge von 420 nm - 480 nm emittiert.

## Revendications

1. Dispositif à diode électroluminescente (DEL) comprenant :
une puce à DEL (410), qui émet une lumière ultraviolette ; et
une multicouche fluorescente (420), qui est constituée d'une pluralité de couches fluorescentes qui émettent une lumière ayant des longueurs d'onde qui diffèrent entre elles lorsqu'elles sont excitées par la lumière ultraviolette émise par la puce à DEL,
dans lequel les couches fluorescentes sont agencées de telle sorte que la lumière d'une longueur d'onde plus longue soit émise par une partie de la multicouche fluorescente plus proche de la puce à DEL, et que la lumière d'une longueur d'onde plus courte soit émise par une partie de la multicouche fluorescente plus éloignée de la puce à DEL ;
**caractérisé en ce que** la multicouche fluorescente comprend une première couche fluorescente (421) qui est formée sur la puce à DEL et contient un matériau fluorescent qui émet une lumière jaune ayant une longueur d'onde de 560 nm - 580 nm, et une deuxième couche fluorescente (422) qui est déposée sur la première couche fluorescente et contient un matériau fluorescent qui émet une lumière bleue ayant une longueur d'onde de 420 nm - 480 nm.
